# EUROPEAN PATENT SPECIFICATION

(11) **EP 0 210 064 B1**
(45) Date of publication and mention of the grant of the patent: **16.06.1993**
(21) Application number: 86305575.2
(22) Date of filing: 21.07.1986
(51) Int. Cl.: G11C 8/00, G11C 17/00

(54) **Variable page ROM**
Festwertspeicher mit veränderlicher Seite
Mémoire morte à page variable

(30) Priority: 22.07.1985 US 757337
(43) Date of publication of application: 28.01.1987
(73) Proprietor: GENERAL INSTRUMENT CORPORATION, New York New York 10153 (US)
(72) Inventor: Luhrmann, Craig J., New York, 11709 (US)
(74) Representative: Allam, Peter Clerk

(56) References cited:
- EP-A- 0 098 755
- EP-A- 0 115 128

## Description

The present invention relates to a read only memory (ROM) device and is particularly concerned with a ROM which can be or has been arranged into one of a plurality of page configurations. It will be shown how a ROM structure having the potential of one of a plurality of page configurations can be given a predetermined one of the page configurations by a mask program.

The invention is concerned with a read only memory device of the kind comprising a matrix array of data storage units; an output buffer to which data in the array is transferable upon addressing the array; a plurality of address inputs for receiving address signals to address the array; and address means connected between the address inputs and the matrix array for addressing the matrix array in response to applied address signals.

Matrix arrays are conventionally addressed by defining the individual data storage locations by their position in the two axes of the array, commonly referred to as rows and columns. In this way, a matrix array of data storage units, such as switches or transistors, can be individually accessed and read to determine their state ("on" or "off", operable or inoperable). To manufacture a ROM device of commercial utility usable with other devices, such as microprocessors, various peripheral circuits are required in order to access and read the storage devices. These circuits include address signals input circuits, address signal decoding circuits, and data transfer circuits.

In order to explain various requirements that arise in the addressing of ROMs under certain circumstances, and particularly where enhanced ROM capacity is to be provided, these requirements will be discussed in the context of a ROM used in a microprocessor system. The ROM is addressed by the microprocessor to provide data needed by the microprocessor.

Typically address signals are applied in parallel to the address inputs of an input buffer. If, for example, the address input signal has 17 bits, the input buffer will have 17 address inputs, each connected to receive a different bit of the address signal. The address circuitry includes a row address decoder and a column address decoder, both of which receive parallel inputs from the input buffer circuit. In accordance with these inputs, the decoder circuits select a particular storage unit from the matrix.

The selected storage unit is read to determine its state which is reflected by either a high or low voltage on an output line. Parallel output lines, one for each column, are connected to an output buffer circuit which, in turn, applies a parallel output signal to a data bus.

The data is programmed into the memory during the fabrication process. Since different data need be programmed into the memories for different applications, it is advisable that the fabrication process be the same for all of the memories of a given type, except for the step during which the information is programmed.

Read only memories are formed on semiconductor chips through the process of layering the chip surface and then etching selected portions of the layers. The portions to be etched are selected by masking the surface through the use of well known processes. The storage unit matrix is programmed through the use of masks and, thus, different masks are utilized to program different information. Information is stored in the memory by physically creating operable or inoperable devices at intersections of the matrix. Once programmed, it cannot be changed, unlike electronically programmable memories which can be erased, either in bulk such as through the use of ultraviolet light or by erasing each unit individually, and reprogrammed.

Mass production of read only memories with different programming is only possible because the structure of the memory matrix and peripheral circuitry is the same for all memories of a given type, regardless of the information to be programmed therein. Otherwise, a different structure would have to be developed for each program, making production costs prohibitive.

When a read only memory is designed, the configuration of the matrix array and the structure of the peripheral circuitry are designed to be compatible. For example, a matrix array of a given size requires a given number of address inputs which must be decoded in a particular manner. If the size or shape (numbers of rows and columns) of the memory matrix is altered, the address circuitry and input circuitry must be correspondingly altered.

Advancing technology has permitted memories of greater capacity to be fabricated. Higher capacity memories have more densely packed matrix arrays of storage units which require less space per unit. Such matrix arrays require larger numbers of address inputs. For example, quadrupling the capacity of the array normally requires twice as many address inputs.

The number of address inputs can be reduced, without loss of capacity, if the memory array is organized into sub-arrays and addressed accordingly. For example, a 4K array of storage units may require ten address inputs--five for the row decoder and five for the column decoder. A 16K array would normally require twice as many address inputs, totalling 20--ten for the row decoder and ten for the column decoder. However, if the 16K array is considered to be four separate 4K sub-arrays, each individually addressable, only a two digit code and, thus, two address inputs, are required to select the proper sub-array. Therefore, only twelve address inputs are required--ten to select the necessary row and column and two to select the necessary sub-array upon which the selected row and column is present. Dividing the array into sub-arrays is a way in which the number of address inputs may be reduced.

Such sub-arrays can be referred to as blocks or banks of storage units, but are most often called "pages" throughout the industry. The process of organizing a matrix array into pages is called "pagination". Random access memories with various page configurations are known. However, because the particular page configuration selected is dependent upon the number of address inputs which are available, and vice versa, different memory designs and peripheral circuit configurations are required for different page configurations.

Increased memory capacity means that additional memory may be obtained in the same size chip. For example, modern 8K read only memory chips can replace older 4K read only memory chips. However, in previously existing systems, which have a fixed number of address inputs, a different ROM design, including a paginated storage array, is required if the higher capacity chip is to be substituted for the previously used memory.

A good example of an increased capacity ROM designed so that it can be used with pre-existing systems having fixed numbers of address inputs is disclosed in United States Patent No. 4,368,515 to Nielsen issued January 11, 1983 entitled "Bank Switchable Memory System." The Nielsen circuit, however, requires a different circuit configuration for each pagination. Thus, different circuits must be designed and developed for use in different pre-existing systems which have different numbers of address inputs.

From the viewpoint of the semiconductor manufacturer, it is advantageous to design and fabricate a single read only memory which can be used for the widest possible variety of applications. Previously, however, each circuit had to be designed and developed individually in accordance with each pagination configuration and address input number. In general, the present invention overcomes this problem through the utilization of a single basic read only memory circuit which is mask programmable to provide a selected one of a variety of different page configurations and, thus, accommodate different numbers of address inputs. This is a great savings in cost because the same basic circuit design can be used for a large variety of applications, simply by utilizing the appropriate pagination masking.

Certain problems arise in the design of a read only memory capable of use as increased capacity memory substitutes in various pre-existing systems. Different pre-existing systems have different numbers of address inputs. The number of address inputs cannot be changed. Therefore, the read only memory, if it is to be used for different pre-existing systems, must be able to accommodate different numbers of address inputs.

Each storage array configuration requires a given number of address inputs. If all of these inputs can be supplied by the regular row and column address inputs from the system, no pagination is required. However, if less than the required number of inputs are available from the system in which the ROM is used through the regular address lines, pagination is required as is a page address signal. The number of required bits in the page address signal is related to the page configuration. Since the page address signal is not available on the regular address inputs, some other way of routing the page address signal to and within the ROM is required.

Within the microprocessor system, the page address signal originates at the microprocessor and is applied to a data bus connecting the microprocessor to the ROM. During the presence of a control signal, the page address signal bits are routed from the data bus to the decoder circuitry.

Once received, the page address signal bits must be preserved in the read only memory for a time equal to the access time to read the desired number of locations on the designated page and, thereafter, erased. Conventional read only memories have no facility for the temporary storage of address signals. The preferred implementation of the present invention described below provides such a facility.

According to one aspect of the present invention there is provided a part-finished read only memory device comprising:
a matrix array (A) of data storage units;
an output buffer (B) to which data in the array (A) is transferable upon addressing the array;
a plurality of address inputs (Aₒ-A₁₆, Pₒ-P₂) for receiving address signals to address the matrix array (A); and
address means (12, 14, 16) connected between said address inputs (Aₒ-A₁₆, Pₒ-P₂) and said matrix array (A) for addressing the matrix array in response to applied address signals;
characterised in that:
said matrix array (A) comprises a plurality of sub-arrays (0-7) formed to enable the matrix array to be addressed according to any one of a plurality of page configurations in which each page is constituted by one or more sub-arrays (0-7),
said address means (12, 14, 16) is formed and is interconnected with said matrix array to enable addressing of the matrix array (A) in any one of said page configurations, and
said address means is mask programmable to configure the address means (12, 14, 16) for addressing the matrix array (A) according to a selected one of said page configurations.

In the immediately following discussion of the preferred practice of the invention the part-finished read only memory device will be simply referred to as the read only memory device, ROM device or ROM for convenience.

By way of example, there will be described hereinafter, a ROM device which has the potential for mask programming into any one of three page configurations. One of these configurations is to treat the matrix array as a single page. The other two configurations are four pages (each in two blocks) and eight pages. These are realisable from a matrix array having eight sub-arrays.

The address means of the ROM device of the invention preferably includes a first decoder means for addressing one axis of all the sub-arrays - this is the column addressing of the embodiments to be described - and second decoder means that is mask programmable to be responsive to address signals for page selection (if required) and for selection within the page on the one axis in order to pass address signals for selection within the page to the first decoder means.

In the preferred ROM device, the address means includes a memory, such as a random address memory, connected to predetermined ones of the address inputs to receive address signals for use by the second decoder means. The manner in which this memory is used in the finally programmed device depends on the page configuration chosen. Specifically in the plural page configurations it is used to temporarily store page selection data.

The address means of the read only memory device preferably further includes an input buffer connected to a predetermined group of the address inputs. This input buffer is mask programmable to block the transmission of signals applied to selected address inputs of this group. The predetermined group in the described embodiment are what would be the conventional row and column inputs for a microprocessor system in which the ROM is employed, though as will be shown one such input can be employed in the four page configuration already mentioned to assist in controlling block selection within each page.

In addition to the first and second decoder means already mentioned, the address means may also include a third decoder means for addressing the other axis of all the matrix sub-arrays - that is the rows in the case already exemplified - and in conjunction with the provision of the input buffer, the latter is connected for the transmission of address signals to both the second and third decoder means. Furthermore the input buffer is mask programmable as to which address inputs of the predetermined group provide address signals for transmission to the second decoder.

In the ROM to be described the address inputs include a group reserved for the receipt of page selection signals. More particularly this page selection group of address inputs is connected as inputs of the memory mentioned above. By this means the ROM can be programmed to a plural page configuration, and where in a microprocessor system the regular address inputs - these form the aforementioned predetermined group to the input buffer - cannot afford the ability to designate pages, the page selection can be made by the microprocessor through the page selection group. The connection of the group to the memory provides the facility for temporary storage of the page selection data within the ROM device itself. Thus where as already discussed the address means includes the first and second decoders, the page selection data stored in the memory is made available to the second decoder.

More particularly the page selection can be effected by having the page selection group of address inputs associated with the output buffer of the ROM. The output buffer is connectable to a data bus to which data from the matrix array is transferable via the output buffer and from which page selection data is receivable. The output buffer has a control input to enable inward transfer of page selection via said page selection group of address inputs.

Another aspect of the invention is a process for producing a read only memory device having data stored therein for reading out according to a predetermined page configuration, the process comprising the steps of:
forming a part-finished device having a structure as set forth above;
mask programming the address means of said part-finished device to configure it for addressing the matrix array according to said predetermined page configuration; and
programming the matrix array of said part-finished device with data for reading out in accord with said predetermined page configuration.

In a still further aspect of the invention there is provided a read only memory device comprising:
a matrix array (A) of data storage units;
an output buffer (B) to which data in the array is transferable upon addressing the array;
a plurality of address inputs (A₀-A₁₆, P₀-P₂) for receiving address signals to address the array; and address means (12, 14, 16) connected between said address inputs and said matrix array for addressing the matrix array in response to applied address signals; characterised in that:
said matrix array (A) comprises a plurality of sub-arrays (0-7), formed to enable the matrix array to be addressed according to any one of a plurality of page configurations in which each page is constituted by one or more sub-arrays,
said address means is interconnected with said matrix array for addressing said matrix array in accord with any of said plurality of page configurations, and
said address means is mask programmed to configure it to address said matrix array according to a predetermined one of said page configurations.

The masked programmed device defined in the preceding paragraph may have the preferred features and facilities already discussed in relation to the mask programmable part-finished device. Thus where the first and second decoder means are provided, in the programmed device the second decoder means will be mask programmed as aforesaid. The provision of an input buffer as previously discussed will have the input buffer mask programmed to block transmission of signals applied to selected address inputs of said predetermined group and, where the input buffer is provided in conjunction with the first and second decoder, to determine which address inputs of the predetermined group connected to the input buffer provide address signals for the second decoder.

The invention and its practice will be further described with reference to the accompanying drawings in which:
Fig. 1 is a block diagram of read only memory of the present invention mask programmed into an eight page configuration;
Fig. 2 is a block diagram of the read only memory of the present invention alternatively mask programmed into a four page configuration; and
Fig. 3 is a block diagram of the read only memory of the present invention alternatively mask programmed into a single page configuration.

The present invention relates to a ROM circuit including a matrix array of storage devices and peripheral circuitry. The peripheral circuitry includes address circuitry and data transfer circuitry. The ROM circuit can be adapted for use in a variety of pre-existing systems, such as electronic games and information retrieval systems, having different fixed numbers of address inputs, through mask programming. The address circuitry, including the decoder circuit and the input buffer circuit can be mask programmed to define various page configurations of the matrix array so as to accommodate pre-existing systems with different numbers of address inputs. The systems are adapted to provide a page address signal on the data bus, in the presence of a command signal. The page address signal is routed through the data transfer circuitry to a storage device where it is retained during use. Preferably, the temporary storage device includes a latching circuit, in the form of a random access memory (RAM).

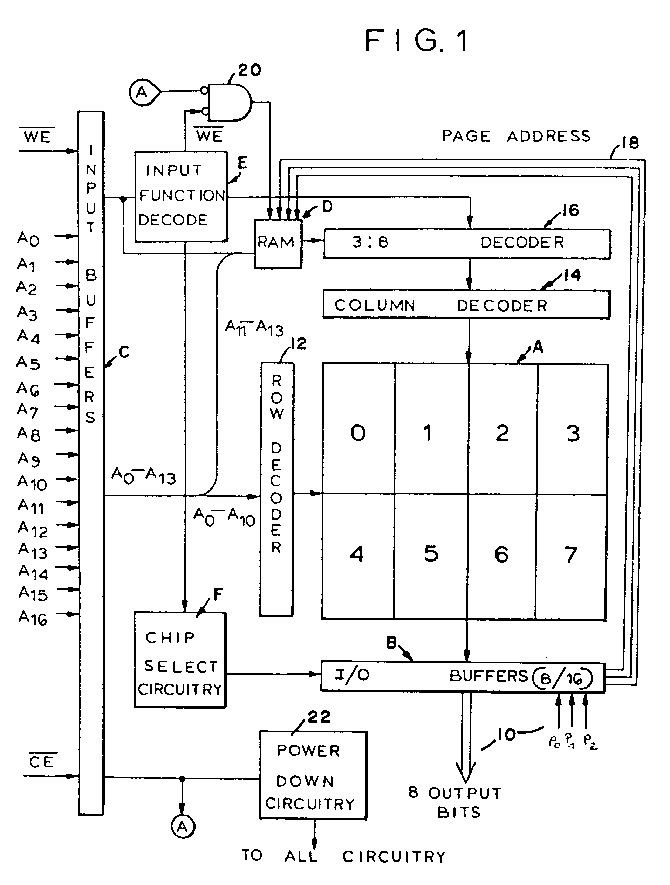

Figs. 1, 2, and 3 are block diagrams of the circuit of the present invention mask programmed for three different page configurations, namely, eight pages of 128K bits each, four pages of 256K bits each, and a single page of 1KK bits, respectively. However, it is to be understood that the illustrated paging configurations constitute examples of a larger variety of different possible paging configurations and are not to be considered a limitation on the present invention. These paging configurations are illustrated for purposes of explanation only.

Each of the figures illustrates the circuit of the present invention as including a 1KK bit matrix array of storage devices, generally designated A, preferably manufactured using a CMOS silicon gate process. The array is designed such that its output configuration is programmable. ROM A can generate either 8-bit or 16-bit output words through the data transfer circuit, generally designated B, which is connected thereto. The data transfer circuit B contains the required number of output buffers and controls the length of the output word. Data transfer circuit B is connected to the data bus 10. Data bus 10 serves to route data accessed from ROM A to the microprocessing unit of the system in which the circuit is employed. Data bus A also functions as an input for the page address signal generated by the microprocessing unit of the system, as explained below.

The storage devices in ROM A are addressed by address circuitry which includes a conventional row decoder 12, a conventional column decoder 14, and a mask programmable page decoder 16. Row decoder 12 has, for example, ten outputs connected in parallel to each of the eight 128K pages in ROM A, designated on Fig . 1 as: "0, 1, 2, 3, 4, 5, 6, and 7". Similarly, column decoder 14 has, for example, eight outputs connected in parallel to the sets of columns which form vertically aligned pages.

Row decoder 12 receives its inputs directly from the output of an input buffer circuit, generally designated C. Column decoder 14 receives its inputs from page decoder 16 which, in turn, is connected to the output of a random access memory, generally designated D. RAM D is connected by means of parallel lines 18 to data transfer circuit B so as to receive the bits of the page address signal therefrom. It is also connected to the output of input buffer circuit C and to the output of a gate 20. Gate 20 receives, as one input, a command (write enable) signal (W̅E̅) from an input function decoder circuit, generally designated E. The output of the function generator E is also connected to decoder 16. The other input of gate 20 is the Chip Enable (C̅E̅) signal which is an input to input buffer circuit C, which is also connected to the power down circuitry 22 of conventional design. Gate 20 causes all of the storage devices in the non-selected pages of ROM A to be in the low power mode. Circuit 22 controls the power status of other circuits in the system.

Input buffer circuit C has, for example, seventeen address inputs denoted A₀...A₁₆. It also has an input to receive the Chip Enable (C̅E̅) signal and an input to receive the command signal which is the Write Enable signal (W̅E̅) from the microprocessing unit. The input buffer circuit C is mask programmable to block the path of selected ones of the address inputs A₀...A₁₆, depending upon the page configuration. Only input buffer circuit C and decoder 16 need be mask programmed to define the page configuration of ROM A. All other components are identical, regardless of the page configuration.

An output of input function decoder E is connected to a chip select circuit, generally designated F, which, in turn, is connected to data transfer circuit B. The chip select circuit F controls the data transfer circuit B to permit the page address signal on data bus 10 to be transferred to lines 18 in the presence of the command signal W̅E̅.

In order to obtain the page configuration illustrated in Fig. 1, that is, eight pages, each having 128K bits of memory, decoder 16 is mask programmed to form a conventional 3:8 decoder, the three inputs being the three bits of the page address signal (P₀, P₁, P₂) which are present on data bus 10 and routed through data transfer circuit B by means of parallel lines 18 to RAM D. RAM D is a slow set up/hold RAM employed to insure temporary storage of the page address signal, which is generated by the system during the presence of the command signal W̅E̅. RAM D will retain the page address signal until the rising edge of the next W̅E̅ signal. The W̅E̅ signal and the page address signal (P₀, P₁, P₂) are generated by the microprocessing unit of the system in which the ROM circuit of the present invention is employed.

Input buffer circuit C is mask programmed such that the paths of three of the address inputs, designated A₁₄, A₁₅, A₁₆ are blocked. Thus, input buffer circuit C passes only address inputs A₀-A₁₃ to the decoders. A₀-A₁₀ are provided as inputs to row decoder 12. A₁₁-A₁₃ are provided as inputs to RAM D, are routed through decoder 16 and along with the output of decoder 16, form the inputs to column decoder 14. The output of column decoder 14 causes the selection of the appropriate page and the appropriate column in that page. In conjunction with the output of row decoder 12, the appropriate location of the selected page is accessed and the data therein fed to data transfer circuit B.

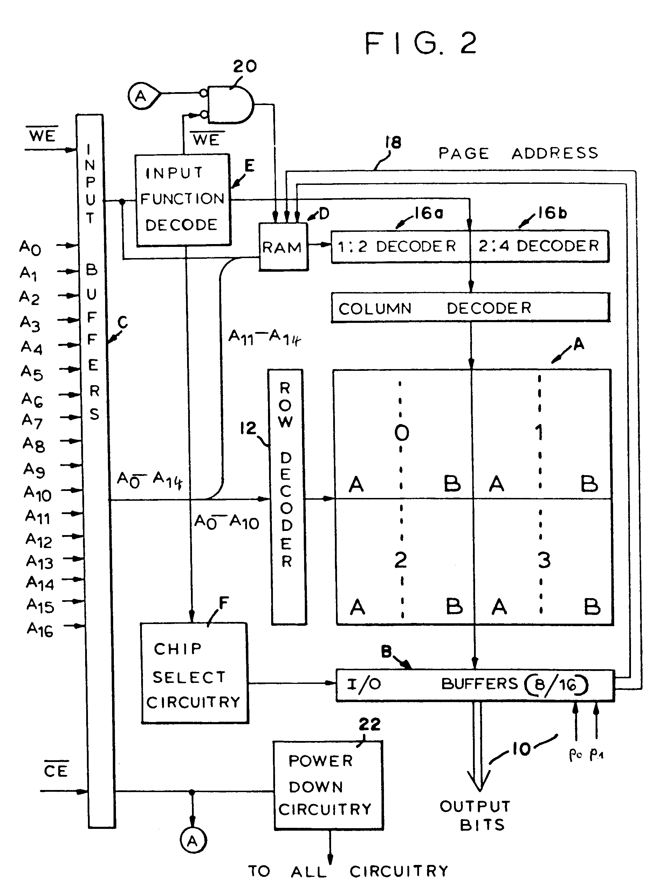

In order to alter the circuit for a four-page configuration, each page having 256K bits, decoder 16 is mask programmed into two separate conventional decode circuits, a 1:2 decoder 16a, and a 2:4 decoder 16b. In this case, only a two-bit page address signal (P₀, P₁) is required. The 2-bit page address signal passes through RAM D and is provided as the input to the 2:4 decoder 16b. This configuration is illustrated in Fig. 2.

Input buffer circuit C is mask programmed to block the paths of address inputs A₁₅ and A₁₆ only. Unlike the previous example, the path of address input A₁₄ is not blocked. Inputs A₀-A₁₄ are routed to the decoders, with inputs A₀-A₁₀ being applied to row decoder 12 and inputs A₁₁-A₁₄ providing an input for RAM D. Input A₁₄ is routed to the 1:2 decoder 16a and is used to select the "A" or "B" section of the selected one of four pages denoted as 0, 1, 2, and 3. The output of decoder 16a and decoder 16b, along with inputs A₁₁-A₁₄, are provided as inputs to column decoder 14. The outputs of decoder 14, in conjunction with the outputs of row decoder 12, serve to select the appropriate page, the appropriate page section, the appropriate column, and the appropriate row of the location to be accessed.

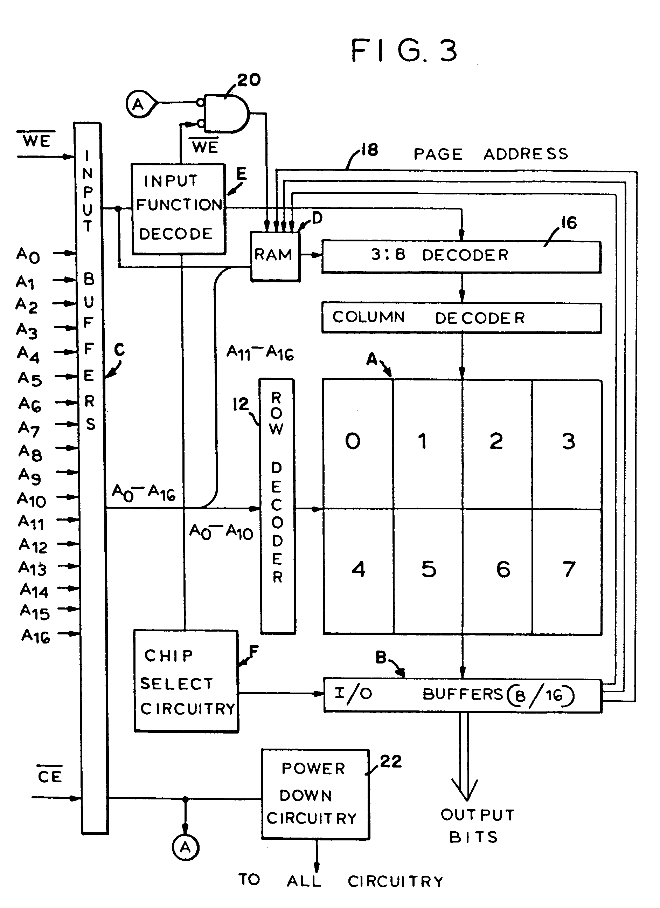

As illustrated in Fig. 3, the circuit of the present invention can also be mask programmed for use as a single page ROM having 1KK bits. No paging is required to access any data, as all locations are directly accessible. In this case, no paging signal is provided on data bus 10 and, thus, none is transferred to RAM D. All of the addressed inputs A₀-A₁₆ to the input buffer are used and all are transferred to the decoders. Inputs A₀-A₁₀ are provided to row decoder 12 and inputs A₁₁-A₁₆ are provided to RAM D. RAM D is never enabled, it simply functions to transfer inputs A₁₁-A₁₆ to decoder 16, which is a conventional 3:8 decoder.

Inputs A₁₄, A₁₅, and A₁₆ form the three inputs to decoder 16. The other inputs A₁₁-A₁₃, along with the output of decoder 16, are provided as inputs to column decoder 14. Column decoder 14, in conjunction with row decoder 12, directly accesses the particular storage unit desired. The command signal (W̅E̅) has no effect on the circuit as the circuit functions as a standard ROM without pagination.

It will now be appreciated that the circuit of the present invention can be adapted for use in a variety of different pagination modes by mask programming the peripheral circuitry, including the address decoder and input buffer circuit. The address decoder is mask programmed to form a selected one of conventional decoder configurations. The input buffer circuitry is mask programmed to block selected address input paths. This enables the circuit of the present invention to be used in a variety of pre-existing systems having fixed numbers of address inputs by adapting the system to generate the necessary page address signal on the data bus in the presence of the write enable command.

Aside from the mask programmability of its page configuration, the ROM circuit of the present invention is unique in that the data transfer circuit, aside from the usual data output function, also provides entrance for the page address signal and routes same to the decoder through a temporary storage circuit. The presence of the temporary storage circuit, in the form of a latch, preferably a random access memory, is in itself novel on a ROM circuit, as conventional ROM circuits have no facility for temporarily storing address signals. Such storage is required in the present invention such that page selection can be maintained as various locations within a particular page are accessed.

While only a single preferred embodiment of the present invention has been disclosed herein for purposes of illustration, it is obvious that many variations and modifications could be made thereto. It is intended to cover all of these variations and modifications which fall within the scope of the present invention, as defined by the following claims:

## Claims

1. A part-finished read only memory device comprising:
a matrix array (A) of data storage units;
an output buffer (B) to which data in the array (A) is transferable upon addressing the array;
a plurality of address inputs (Aₒ-A₁₆, Pₒ-P₂) for receiving address signals to address the matrix array (A); and
address means (12, 14, 16) connected between said address inputs (Aₒ-A₁₆, Pₒ-P₂) and said matrix array (A) for addressing the matrix array in response to applied address signals;
characterised in that:
said matrix array (A) comprises a plurality of sub-arrays (0-7) formed to enable the matrix array to be addressed according to any one of a plurality of page configurations in which each page is constituted by one or more sub-arrays (0-7),
said address means (12, 14, 16) is formed and is interconnected with said matrix array to enable addressing of the matrix array (A) in any one of said page configurations, and
said address means is mask programmable to configure the address means (12, 14, 16) for addressing the matrix array (A) according to a selected one of said page configurations.

2. A read only memory device according to Claim 1 in which said address means (12, 14, 16) includes first decoder means (14) for addressing one axis of all the matrix sub-arrays (0-7) and second decoder means (16) mask programmable to be responsive to address signals for page selection, if required, and for selection within the page on said one axis in order to pass address signals for selection within the page to said first decoder means (14).

3. A read only memory device according to Claim 2 in which said address means (12, 14, 16) further includes a memory (D) connected to predetermined ones of the address inputs (Aₒ-A₁₆, Pₒ-P₂) to receive address signals for use by said second decoder means.

4. A read only memory device according to Claim 3 in which said memory (D) is a random address memory.

5. A read only memory device according to any one of Claims 1 to 4 in which said address means further includes an input buffer (C) connected to a predetermined group (Aₒ-A₁₆) of said address inputs, said input buffer (C) being mask programmable to block the transmission of signals applied to selected address inputs of said predetermined group.

6. A read only memory device as claimed in Claim 5 as appended to Claim 2, 3 or 4 in which said address means (12, 14, 16) includes third decoder means (12) for addressing the other axis of all the matrix sub-arrays (0-7) and in which said input buffer (C) is connected for the transmission of address signals to both said second (16) and third (12) decoder means and is mask programmable as to which address inputs of said group (Aₒ-A¹₆) provide address signals for transmission to said second decoder (16).

7. A read only memory device as claimed in any preceding claim in which said address inputs include a group (Pₒ-P₂) of address inputs reserved for receipt of page selection address signals.

8. A read only memory as claimed in Claim 7 as appended to Claim 3 or 4 in which said page selection group of address inputs (Pₒ-P₂) is connected as inputs to said memory (D).

9. A read only memory device as claimed in any preceding claim in which one of the plurality of page configurations is to treat said matrix array as a single page.

10. A process for producing a read only memory device having data stored therein for reading out according to a predetermined page configuration, the process comprising the steps of:
forming a part-finished device having a structure as claimed in claim 1;
mask programming the address means of said part-finished device to configure it for addressing the matrix array according to said predetermined page configuration; and
programming the matrix array of said part-finished device with data for reading out in accord with said predetermined page configuration.

11. A read only memory device comprising:
a matrix array (A) of data storage units;
an output buffer (B) to which data in the array is transferable upon addressing the array;
a plurality of address inputs (A₀-A₁6, P₀-P₂) for receiving address signals to address the array; and address means (12, 14, 16) connected between said address inputs and said matrix array for addressing the matrix array in response to applied address signals; characterised in that:
said matrix array (A) comprises a plurality of sub-arrays (0-7), formed to enable the matrix array to be addressed according to any one of a plurality of page configurations in which each page is constituted by one or more sub-arrays,
said address means is interconnected with said matrix array for addressing said matrix array in accord with any of said plurality of page configurations, and
said address means is mask programmed to configure it to address said matrix array according to a predetermined one of said page configurations.

12. A read only memory device as claimed in Claim 11 in which said address means (12, 14, 16) includes first decoder means (14) for addressing one axis of all the matrix sub-arrays and a second decoder means (16) mask programmed as aforesaid and responsive to address signals for page selection, if required, and for selection within the page on said one axis, said second decoder means (16) being operable to pass address signals for selection within the page to said first decoder means (14).

13. A read only memory device as claimed in Claim 12 in which said address means (12, 14, 16) further includes a memory (D) connected to predetermined ones of the address inputs (Aₒ-A₁₆, Pₒ-P₂) to receive address signals for use by said second decoder means (16).

14. A read only memory device as claimed in Claim 13 in which said memory (D) is a random address memory.

15. A read only memory device as claimed in any one of Claims 11 to 14 in which said address means (12, 14, 16) further includes an input buffer (C) connected to a predetermined group (Aₒ-A₁₆) of said address inputs, said input buffer (C) being mask programmed as aforesaid to block the transmission of signals applied to selected address inputs of said predetermined group.

16. A read only memory device as claimed in Claim 15 as appended to Claims 12, 13 or 14 in which said address means (12, 14, 16) includes third decoder means (12) for addressing the other axis of all the matrix sub-arrays (0-7) and in which said input buffer (C) is connected for the transmission of address signals to both said second (16) and third (12) decoder means and is mask programmed as aforesaid to determine which address inputs of said predetermined group (Aₒ-A₁₆) provide address signals for said second decoder (16).

17. A read only memory device as claimed in any one of Claims 11 to 16 in which said predetermined page configuration comprises a plurality of pages and in which said address inputs include a group (Pₒ-P₂) of address inputs serving only for receipt of page selection address signals.

18. A read only memory device as claimed in Claim 17 as appended to Claim 13 or 14 in which said page selection group (Pₒ-P₂) of address inputs is connected as inputs to said memory.

19. A read only memory as claimed in any one of Claims 11-16 in which said predetermined page configuration treat said matrix array (A) as a single page.

20. A read only memory device as claimed in Claim 7, 8, 17 or 18 in which said page selection group of address inputs (Pₒ-P₂) are associated with the output buffer (B), the output buffer (B) being connectable to a data bus (10) to which data from the matrix array (A) is transferable via the output buffer (B) and from which page selection data is receivable, said output buffer (B) having a control input to enable inward transfer of page selection data via said page selection group of address inputs (Pₒ-P₂).

## Patentansprüche

1. Teilweise vollendete Festwertspeichervorrichtung, die folgendes umfasst:
eine Matrixanordnung (A) von Datenspeichereinheiten;
einen Ausgabepuffer (B), an den Daten in der Anordnung (A) übertragen werden können, wenn die Anordnung adressiert wird;
eine Vielzahl von Adresseneingaben (A₀-A₁₆, P₀-P₂) zum Empfang von Adressensignalen, um die Matrixanordnung (A) zu adressieren; und
Adressenmittel (12, 14, 16), die zwischen den Adresseneingaben (A₀-A₁₆, P₀-P₂) und der Matrixanordnung (A) angeschlossen sind, um die Matrixanordnung in Reaktion auf die aufgebrachten Adressensignale zu adressieren;
dadurch gekennzeichnet, dass:
die Matrixanordnung (A) eine Vielzahl von Unteranordnungen (0-7) umfasst, die gebildet sind, um die Matrixanordnung zu befähigen, gemäss irgendeiner einer Vielzahl von Seitengestaltungen adressiert zu werden, in der jede Seite aus einer oder mehreren Unteranordnungen (0-7) besteht,
wobei das Adressenmittel (12, 14, 16) gebildet ist und mit der Matrixanordnung zusammengeschaltet ist, um Adressierung der Matrixanordnung (A) in irgendeiner der Seitengestaltungen zu befähigen,
wobei das Adressenmittel maskenprogrammierbar ist, um das Adressenmittel (12, 14, 16) zur Adressierung der Matrixanordnung (A) nach einer ausgewählten Seitengestaltung zu gestalten.

2. Festwertspeichervorrichtung nach Anspruch 1, in der das Adressenmittel (12, 14, 16) ein erstes Dekodiermittel (14) einschliesst, um eine Achse von allen Matrixunteranordnungen (0-7) zu adressieren, und ein zweites Dekodiermittel (16), das maskenprogrammierbar ist, um erforderlichenfalls auf Adressensignale für Seitenauswahl zu reagieren, und für Auswahl innerhalb der Seite auf der einen Achse, um Adressensignale zur Auswahl innerhalb der Seite an das erste Dekodiermittel (14) weiterzugeben.

3. Festwertspeichervorrichtung nach Anspruch 2, in der das Adressenmittel (12, 14, 16) weiterhin einen Speicher (D) einschliesst, der an vorbestimmte Adresseneingaben (A₀-A₁₆, P₀-P₂) angeschlossen ist, um Adressensignale zur Benutzung von dem zweiten Dekodiermittel zu empfangen.

4. Festwertspeichervorrichtung nach Anspruch 3, in der der Speicher (D) ein Speicher mit wahlfreiem Zugriff ist.

5. Festwertspeichervorrichtung nach einem der Ansprüche 1 bis 4, in der das Adressenmittel weiterhin einen Eingabepuffer (C) einschliesst, der an eine vorbestimmte Gruppe (A₀-A₁₆) der Adresseneingaben angeschlossen ist, wobei der Eingabepuffer (C) maskenprogrammierbar ist, um die Übertragung von Signalen, die auf ausgewählte Adresseneingaben der vorbestimmten Gruppe aufgebracht werden, zu blockieren.

6. Festwertspeichervorrichtung nach Anspruch 5, der von Anspruch 2, 3, oder 4 abhängig ist, in der das Adressenmittel (12, 14, 16) ein drittes Dekodiermittel (12) einschliesst, um die andere Achse aller Matrixunteranordnungen (0-7) zu adressieren, und in der der Eingabepuffer (C) zur Übertragung von Adressensignalen an sowohl das zweite (16) als auch das dritte (12) Dekodiermittel angeschlossen ist, und maskenprogrammierbar ist, zu welchen Adresseneingaben der Gruppe (A₀-A₁₆) Adressensignale zur Übertragung zu dem zweiten Dekodierer (16) liefern.

7. Festwertspeichervorrichtung nach einem der vorhergehenden Ansprüche, in der die Adresseneingaben eine Gruppe (P₀-P₂) von Adresseneingaben einschliessen, die zum Empfang von Seitenauswahladressensignalen reserviert sind.

8. Festwertspeichervorrichtung nach Anspruch 7, der von Anspruch 3 oder 4 abhängig ist, in der die Seitenauswahlgruppe von Adresseneingaben (P₀-P₂) als Eingaben an den Speicher (D) angeschlossen ist.

9. Festwertspeichervorrichtung nach einem der vorhergehenden Ansprüche, in der eine der Vielzahl von Seitengestaltungen ist, die Matrixanordnung als eine einzige Seite zu behandeln.

10. Verfahren zur Herstellung einer Festwertspeichervorrichtung mit darin gespeicherten Daten, um gemäss einer vorbestimmten Seitengestaltung auszulesen, wobei das Verfahren die folgenden Schritte umfasst:
es wird eine teilweise vollendete Vorrichtung mit einer wie in Anspruch 1 beanspruchten Struktur gebildet;
das Adressenmittel der teilweise vollendeten Vorrichtung wird maskenprogrammiert, um es zur Adressierung der Matrixanordnung gemäss der vorbestimmten Seitengestaltung zu gestalten;
und
die Matrixanordnung der teilweise vollendeten Vorrichtung wird mit Daten zum Auslesen in Übereinstimmung mit der vorbestimmten Seitengestaltung programmiert.

11. Festwertspeichervorrichtung, die folgendes umfasst:
eine Matrixanordnung (A) von Datenspeichereinheiten;
einen Ausgabepuffer (B), an den Daten in der Anordnung übertragen werden können, wenn die Anordnung adressiert wird;
eine Vielzahl von Adresseneingaben (A₀-A₁₆, P₀-P₂), zum Empfang von Adressensignalen, um die Anordnung zu adressieren; und
ein Adressenmittel (12, 14, 16), das zwischen den Adresseneingaben und der Matrixanordnung angeschlossen ist, um die Matrixanordnung in Reaktion auf aufgebrachte Adressensignale zu adressieren;
dadurch gekennzeichnet, dass:
die Matrixanordnung (A) eine Vielzahl von Unteranordnungen (0-7) umfasst, die gebildet sind, um die Matrixanordnung zu befähigen, gemäss irgendeiner einer Vielzahl von Seitengestaltungen adressiert zu werden, in der jede Seite aus einer oder mehreren Unteranordnungen besteht,
wobei das Adressenmittel mit der Matrixanordnung zusammengeschaltet ist, um die Matrixanordnung in Übereinstimmung mit irgendeiner der Vielzahl von Seitengestaltungen zu adressieren, und
wobei das Adressenmittel maskenprogrammiert ist, um es zur Adressierung der Matrixanordnung nach einer vorbestimmten Seitengestaltung zu gestalten.

12. Festwertspeichervorrichtung nach Anspruch 11, in der das Adressenmittel (12, 14, 16) ein erstes Dekodiermittel (14) einschliesst, um eine Achse von allen Matrixunteranordnungen zu adressieren, und ein zweites Dekodiermittel (16), das wie obig maskenprogrammiert ist, und auf Adressensignale zur Seitenauswahl, wenn erwünscht, reagiert, und zur Auswahl in der Seite auf der einen Achse, wobei das zweite Dekodiermittel (16) betrieben werden kann, um Adressensignale zur Auswahl in der Seite an das erste Dekodiermittel (14) weiterzugeben.

13. Festwertspeichervorrichtung nach Anspruch 12, in der das Adressenmittel (12, 14, 16) weiterhin einen Speicher (D) einschliesst, der an vorbestimmte Adresseneingaben (A₀-A₁₆, P₀-P₂) angeschlossen ist, um Adressensignale zur Benutzung von dem zweiten Dekodiermittel (16) zu empfangen.

14. Festwertspeichervorrichtung nach Anspruch 13, in der der Speicher (D) ein Speicher mit wahlfreiem Zugriff ist.

15. Festwertspeichervorrichtung nach einem der Ansprüche 11 bis 14 beanspruchte Festwertspeichervorrichtung, in der das Adressenmittel (12, 14, 16) weiterhin einen Eingabepuffer (C) einschliesst, der an eine vorbestimmte Gruppe (A₀-A₁₆) der Adresseneingaben angeschlossen ist, wobei der Eingabepuffer (C) wie obig maskenprogrammiert wird, um die Übertragung von Signalen, die auf ausgewählte Adresseneingaben der vorbestimmten Gruppe aufgebracht sind, zu blockieren.

16. Festwertspeichervorrichtung nach Anspruch 15, der von Ansprüchen 12, 13 oder 14 abhängig ist, in der das Adressenmittel (12, 14, 16) ein drittes Dekodiermittel (12) einschliesst, um die andere Achse aller Matrixunteranordnungen (0-7) zu adressieren, und in der der Eingabepuffer (C) zur Übertragung von Adressensignalen an sowohl das zweite (16) als auch das dritte (12) Dekodiermittel angeschlossen ist, und wie obig maskenprogrammiert ist, um zu bestimmen, welche Adresseneingaben der vorbestimmten Gruppe (A₀-A₁₆) Adressensignale für den zweiten Dekodierer liefern.

17. Festwertspeichervorrichtung nach einem der Ansprüche 11 bis 16, in der die vorbestimmte Seitengestaltung eine Vielzahl von Seiten umfasst, und in der die Adresseneingaben eine Gruppe (P₀-P₂) von Adresseneingaben einschliessen, die nur zum Empfang von Seitenauswahladressensignalen dienen.

18. Festwertspeichervorrichtung nach Anspruch 17, der von Anspruch 13 oder 14 abhängig ist, in der die Seitenauswahlgruppe (P₀-P₂) von Adresseneingaben als Eingaben an den Speicher angeschlossen ist.

19. Festwertspeichervorrichtung nach einem Ansprüche 11 - 16, in der die vorbestimmte Seitengestaltung die Matrixanordnung (A) als eine einzige Seite behandelt.

20. Festwertspeichervorrichtung nach Anspruch 7, 8, 17 oder 18, in der die Seitenauswahlgruppe von Adresseneingaben (Pₒ-P₂) dem Ausgabepuffer (B) zugeordnet ist, wobei der Ausgabepuffer (B) an einen Datenbus (10) angeschlossen werden kann, an den Daten von der Matrixanordnung (A) mittels des Ausgabepuffers (B) übertragen werden können, und von welchem Seitenauswahldaten empfangen werden können, wobei der Ausgabepuffer (B) eine Kontrolleingabe hat, um innere Übertragung von Seitenauswahldaten mittels der Seitenauswahlgruppe von Adresseneingaben (P₀-P₂) zu befähigen.

## Revendications

1. Un dispositif à mémoire fixe de lecture partiellement achevée comportant:
un ensemble de matrice (A) d'éléments de mémoire de données;
un tampon de sortie (B) admettant le transfert des données d'ensemble (A) suite à l'adressage de l'ensemble;
une pluralité d'entrées d'adresse (Aₒ-A₁₆, Pₒ-P₂) pour recevoir les signaux d'adresse permettant d'adresser l'ensemble de matrice (A); et
des moyens d'adresse (12, 14, 16) connectés entre lesdites entrées d'adresse (Aₒ-A₁₆, Pₒ-P₂) et ledit ensemble de matrice (A) pour adresser l'ensemble de matrice en réponse aux signaux appliqués d'adresse;
**caractérisé en ce que:**
ledit ensemble de matrice (A) comporte une pluralité de sous-ensembles (0-7) formés pour permettre à l'ensemble de matrice d'être adressé selon l'une quelconque d'une pluralité de configurations de page dont chaque page consiste d'un ou de plusieurs sous-ensembles (0-7);
lesdits moyens d'adresse (12, 14, 16) sont formés et interconnectés avec ledit ensemble de matrice pour permettre l'adressage de l'ensemble de matrice (A) en l'une quelconque des configurations de page, et
ledit moyen d'adresse est programmé par masque pour configurer les moyens d'adresse (12, 14, 16) pour adresser l'ensemble de matrice (A) en conformité avec une certaine unité sélectionnée desdites configurations de page.

2. Un dispositif à mémoire fixe de lecture selon la revendication 1 dont lesdits moyens d'adresse (12, 14, 16) prévoient un premier moyen décodeur (14) pour adresser un axe unique de tous les sous-ensembles de matrice (0-7) et un deuxième moyen décodeur (16) à programmation par masque répondant au besoin aux signaux d'adresse de sélection de page, et pour la sélection sur la page dans ledit axe unique de façon à passer audit premier moyen décodeur (14) les signaux d'adresse pour la sélection sur la page.

3. Un dispositif à mémoire fixe de lecture selon la revendication 2 dont lesdits moyens d'adresse (12, 14, 16) comportent en outre une mémoire (D) connectée à chacune des entrées prédéterminées d'adresse (Aₒ-A₁₆, Pₒ-P₂) pour recevoir les signaux d'adresse pour l'emploi par ledit deuxième moyen décodeur.

4. Un dispositif à mémoire fixe de lecture selon la revendication 3 dont ladite mémoire (D) est une mémoire à accès sélectif.

5. Un dispositif à mémoire fixe de lecture selon l'une quelconque des revendications 1 à 4 dont ledit moyen d'adresse comporte en outre un tampon d'entrée (C) connecté à un groupe prédéterminé (Aₒ-A₁₆) desdites entrées d'adresse, ledit tampon d'entrée (C) étant à programmation par masque pour bloquer la transmission de signaux appliqués aux entrées sélectionnées d'adresse dudit groupe prédéterminé.

6. Un dispositif à mémoire fixe de lecture tel que revendiqué à la revendication 5 mise en annexe aux revendications 2, 3 ou 4 dont lesdits moyens d'adresse (12, 14, 15) comportent un troisième moyen décodeur (12) pour adresser l'autre axe de tous les sous-ensembles de matrice (0-7) et dont ledit tampon d'entrée (C) est connecté pour la transmission de signaux d'adresse à chacun desdits deuxième (16) et troisième (12) moyen décodeur et comporte la programmation par masque pour ce qui est des entrées d'adresse dudit groupe (Aₒ-A¹₆) qui apportent les signaux d'adresse à transmettre audit deuxième décodeur (16).

7. Un dispositif à mémoire fixe de lecture tel que revendiqué en l'une quelconque des revendications précédentes dans laquelle lesdites entrées d'adresse comportent un groupe (Pₒ-P₂) d'entrées d'adresse réservé à la réception des signaux d'adresse de sélection de page.

8. Un dispositif à mémoire fixe de lecture tel que revendiqué à la revendication 7 mis en annexe à la revendication 3 ou 4 dont ledit groupe de sélection de page des entrées d'adresse (Pₒ-P₂) est connecté au titre d'entrées en ladite mémoire (D).

9. Un dispositif à mémoire fixe de lecture tel que revendiqué en l'une quelconque des revendications précédentes dont l'une d'une pluralité de configurations de page est prévue pour traiter ledit ensemble de matrice comme page unique.

10. Procédé pour produire un dispositif à mémoire fixe de lecture ayant en mémoire des données de lecture selon une configuration prédéterminée de page, le procédé comportant les phases suivantes:
la formation d'un dispositif partiellement achevé ayant une structure telle que revendiquée à la revendication 1;
la programmation par masque des moyens d'adresse dudit dispositif partiellement achevé pour le configurer à l'effet d'adresser l'ensemble de matrice selon ladite configuration prédéterminée de page; et
la programmation de l'ensemble de matrice dudit dispositif partiellement achevé avec des données pour la lecture en conformité avec ladite configuration prédéterminée de page.

11. Un dispositif à mémoire fixe de lecture comportant:
un ensemble de matrice (A) d'éléments de mémoire de données;
un tampon de sortie (B) auquel est effectué le transfert des données de l'ensemble suivant l'adressage de l'ensemble;
une pluralité d'entrées d'adresse (Aₒ-A₁₆, Pₒ-P₂) pour recevoir les signaux d'adresse de façon à adresser l'ensemble; et des moyens d'adresse (12, 14, 16) connectés entre lesdites entrées d'adresse et ledit ensemble de matrice pour adresser l'ensemble de matrice en réponse aux signaux d'adresse ainsi appliqués; **caractérisé en ce que**:
ledit ensemble de matrice (A) comporte une pluralité de sous-ensembles (0-7) formés pour permettre à l'ensemble de matrice d'être adressé selon l'une quelconque d'une pluralité de configurations de page dont chaque page consiste d'un ou de plusieurs sous-ensembles,
ledit moyen d'adresse est interconnecté avec ledit ensemble de matrice pour adresser ledit ensemble de matrice en conformité avec l'une quelconque de ladite pluralité de configurations de page, et
ledit moyen d'adresse est programmé par masque pour le configurer de façon à adresser ledit ensemble de matrice en conformité avec une certaine page prédéterminée desdites configurations de page.

12. Un dispositif à mémoire fixe de lecture tel que revendiqué à la revendication 11 dont lesdits moyens d'adresse (12, 14, 16) comportent un premier moyen décodeur (14) pour adresser un axe unique de tous les sous-ensembles de matrice et un deuxième moyen décodeur (16) programmé par masque tel qu'indiqué ci-avant et répondant au besoin aux signaux d'adresse pour la sélection de page, et pour la sélection sur la page dans ledit axe unique, ledit deuxième moyen décodeur (16) fonctionnant pour passer audit premier moyen décodeur (14) les signaux d'adresse pour la sélection sur la page.

13. Un dispositif à mémoire fixe de lecture tel que revendiqué à la revendication 12 dont lesdits moyens d'adresse (12, 14, 16) comportent en outre une mémoire (D) connectée à certaines entrées prédéterminées d'adresse (Aₒ-A₁₆, Pₒ-P₂) pour recevoir les signaux d'adresse pour l'emploi par ledit deuxième moyen décodeur (16).

14. Un dispositif à mémoire fixe de lecture tel que revendiqué à la revendication 13 dont ladite mémoire (D) est une mémoire d'adresse aléatoire.

15. Un dispositif à mémoire fixe de lecture tel que revendiqué en l'une quelconque des revendications 11 à 14 dont lesdits moyens d'adresse (12, 14, 16) comportent en outre un tampon d'entrée (C) connecté à un groupe prédéterminé (Aₒ-A₁₆) desdites entrées d'adresse, ledit tampon d'entrée état programmé par masque tel qu'indiqué auparavant de façon bloquer la transmission de signaux appliqués aux entrées sélectionnées d'adresse dudit groupe prédétérminé.

16. Un dispositif à mémoire fixe de lecture tel que revendiqué à la revendication 15 mise en annexe aux revendications 12, 13, 14 dont lesdits moyens d'adresse (12, 14, 16) comportent en outre un troisième moyen décodeur (12) pour adresser l'autre axe de tous les sous-ensembles de matrice (0-7) et dont ledit tampon d'entrée (C) est connecté pour la transmission de signaux d'adresse auxdits deuxième (16) et troisième (12) moyens décodeurs et programmé par masque tel qu'indiqué ci-avant pour déterminer celles des adresses d'entrées dudit groupe prédéterminé (Aₒ-A₁₆) qui assurent les signaux d'adresse pour le deuxième décodeur (16).

17. Un dispositif à mémoire fixe de lecture tel que revendiqué à l'une quelconque des revendications 11 à 16 dont ladite configuration prédéterminée de page comporte une pluralité de pages et dont les entrées d'adresse comportent un groupe (Pₒ-P₂) d'entrées d'adresse servant exclusivement à la réception des signaux d'adresse de sélection de page.

18. Un dispositif à mémoire fixe de lecture tel que revendiqué à la revendication 17 mise en annexe à la revendication 13 ou 14 dont ledit groupe de sélection de page (Pₒ-P₂) d'entrées d'adresse est connecté sous forme d'entrées à ladite mémoire.

19. Un dispositif à mémoire fixe de lecture tel que revendiqué en l'une quelconque des revendication 11-16 dont ladite configuration prédéterminée de page traite ledit ensemble de matrice (A) comme page unique.

20. Un dispositif à mémoire fixe de lecture tel que revendiqué aux revendication 7, 8, 17 ou 18 dont ledit groupe de sélection de page d'entrées d'adresse (Pₒ-P₂) est associé au tampon de sortie (B), le tampon de sortie (B) étant connectable à un bus de données (10) auquel les données de l'ensemble de matrice (A) admet le transfert par l'intermédiaire du tampon de sortie (B) et dont les données de sélection de page sont recevables, ledit tampon de sortie (B) ayant une commande d'entrée permettant le transfert intérieur des données de sélection de page par l'intermédiaire dudit groupe de sélection de page d'entrées d'adresse (Pₒ-P₂).
